Europäisches Patentamt

European Patent Office

Office européen des brevets

(11) Publication number: **0 484 056 A1**

(12) **EUROPEAN PATENT APPLICATION**

(21) Application number: 91309854.7

(22) Date of filing: 24.10.91

(51) Int. Cl.⁵: **H01L 21/20, H01L 21/331, H01L 21/335**

(30) Priority: **24.10.90 JP 286467/90**

(43) Date of publication of application:
**06.05.92 Bulletin 92/19**

(84) Designated Contracting States:
**DE FR GB**

(71) Applicant: **FUJITSU LIMITED**
**1015, Kamikodanaka Nakahara-ku**
**Kawasaki-shi Kanagawa 211 (JP)**

(72) Inventor: **Fujioka, Hiroshi, c/o Fujitsu Limited**
**1015, Kamikodanaka, Nakahara-ku**
**Kawasaki-shi, Kanagawa 211 (JP)**

(74) Representative: **Silverman, Warren et al**
**HASELTINE LAKE & CO. Hazlitt House 28**
**Southampton Buildings Chancery Lane**
**London WC2A 1AT (GB)**

(54) Process for forming germanium-containing layer on oxygen-containing insulation layer.

(57) A process for forming a germanium-containing layer on a substrate having an oxygen-containing insulation layer on a surface thereof, said process comprising the steps of forming a protection layer on a surface of the oxygen-containing insulation layer, said protection layer preventing a decomposition of the oxygen-containing layer due to a reaction of oxygen in the oxygen-containing layer and a germanium-containing gas, and then forming the germanium-containing layer on the substrate by a chemical vapor deposition using the germanium-containing gas.

*Fig. 1A*

*Fig. 1B*

Jouve, 18, rue Saint-Denis, 75001 PARIS

The present invention relates to a process for forming a germanium-containing layer on a substrate having an oxygen-containing insulation layer on a surface thereof.

For example, hetero-junction bipolar transistors utilizing a hetero-junction between silicon and silicon-germanium (Si-Ge) or germanium are expected to provide a high speed transistor having a switching speed higher than a conventional silicon bipolar transistor by a factor of several to ten, by already established technology. In order to attain this, a base layer of germanium or silicon-germanium must be epitaxially grown on a silicon substrate in which an element isolation and a collector are already formed. This epitaxial growth is performed by a chemical vapor deposition (CVD) from a source gas of gerane ($GeH_4$) or a mixture of gerane ($GeH_4$) and silane ($SiH_4$).

On the other hand, in the silicon substrate on which the Si-Ge is to be epitaxially grown, isolation insulation layers and interlayer insulation layers or the like made of silicon dioxide ($SiO_2$) or the like are formed. The reasons for use of $SiO_2$ are because an excellent $SiO_2$ can be formed by thermal oxydation of the silicon substrate and because the $SiO_2$ has a low dielectric constant and others, and such $SiO_2$ insulation layers cannot be easily replaced by other insulating layers.

Nevertheless, during a deposition of Si-Ge by a CVD, $GeH_4$ contacts with an oxygen-containing insulation layer, such as an $SiO_2$ layer, and a material which easily evaporates, for example, germanium monooxide (GeO), is formed by a reaction of the $GeH_4$ with the oxygen-containing insulation layer, which material contaminates the gaseous source gas. As a result, an epitaxially grown Si-Ge layer involves oxygen so that crystal defects are formed. Such defects disadvantageously form recombination centers having a deep state at the hetero interface. Further, the surface of the oxygen-containing insulation layer is disadvantageously roughened by losing oxygen.

These types of problems are commonly involved in processes for forming a germanium-containing layer on a substrate having an oxygen-containing layer on the surface thereof.

An object of the present invention is to solve the above problems and to provide a process for forming a germanium-containing layer on a substrate having an oxygen-containing layer on the surface thereof without the above problems.

According to a first aspect of the present invention there is provided a process for forming a germanium-containing layer on a substrate having an oxygen-containing insulation layer on a surface thereof, said process comprising the steps of: forming a protection layer on a surface of the oxygen-containing insulation layer, said protection layer preventing a decomposition of said oxygen-containing insulation layer as a result of reaction with a germanium-containing gas; and then forming the germanium-containing layer on the substrate by a chemical vapor deposition using the germanium-containing gas.

According to a second aspect of the present invention there is provided a process for manufacturing a semiconductor device, comprising the steps of: locally forming an oxygen-containing insulation layer on a semiconductor substrate, said insulation layer having a top surface and a side wall, a portion of a surface of said semiconductor substrate being exposed; forming a protection layer on the top surface and the side wall of the oxygen-containing insulation layer, said protection layer preventing a decomposition of said oxygen-containing insulation layer due to a reaction of oxygen in said oxygen-containing insulation layer with a germanium-containing gas; and then forming a germanium-containing layer on the exposed semiconductor substrate by a chemical vapor deposition using the germanium-containing gas.

The germanium-containing layer may be, for example, germanium, silicon-germanium

The oxygen-containing insulation layer may be, for example, silicon dioxide, phospho-silicate glass (PSG), boro-phospho-silicate glass(BPSG).

The protection layer may be any material that does not contain oxygen or does not release a reaction product of oxygen during the deposition of the germanium-containing layer at a temperature of the deposition and therefore may be an insulator, a metal or a semiconductor, but examples of preferred materials for the protection layer are insulators such as silicon nitride ($Si_3N_4$), silicon oxynitride (SiON), etc. Although silicon oxynitride contains oxygen, it is not reactive with a gaseous germanium source and does not release a reaction product of oxygen at least up to about 650°C and therefore can be used as a protection layer in a process for depositing a germanium-containing layer performed at a temperature up to about 650°C according to the present invention. Also, metals such as tantalun and molybdenum or semiconductors such as silicon and even germanium may be used.

Here, typical germanium source gases include gerane ($GeH_4$) and digerane ($Ge_2H_6$). The germanium source gas may be used alone or in combination with other source gases such as silane, disilane, etc. Typically, gerane ($GeH_4$) is decomposed at a temperature of about 450°C, silane ($SiH_4$) is decomposed at a temperature of about 900°C, and a mixture of gerane ($GeH_4$) and silane ($SiH_4$) is decomposed at a temperature between about 450°C and about 900°C. The germanium-containing layer may further contain a dopant.

In a preferred embodiment, a germanium-containing layer is deposited on a substrate on which an oxygen-containing insulation layer is formed in a selected area only. In this case, the protection layer is also locally formed on the top surface and side wall of the oxygen-containing insulation layer and a remaining area of the surface of the substrate is exposed and the germanium-containing layer is deposited thereon. Thus, an epitaxial growth may be made.

The present invention may be applied to various devices such as a hetero-junction bipolar transistor (HBT) or high electron mobility transistor (HEMT).

For a better understanding of the invention, and to show how the same may be carried into effect, reference will now be made, by way of example, to the accompanying drawings, in which:-

Figures 1A and 1B show a first embodiment of the present invention;

Fig. 2A and 2B show a second embodiment of the present invention;

Fig. 3A to 3F show an Example of the present invention in which hetero-bipolar transistor (HBT) is manufactured;

Fig. 4 shows a relationship between the n value (diode factor) and a thickness of an $SiO_2$ layer 21 formed in the HBT shown in Figs. 3A to 3F; and

Fig. 5 shows another application of the present invention in which a Ge-containing layer is formed as an interconnection layer between transistors.

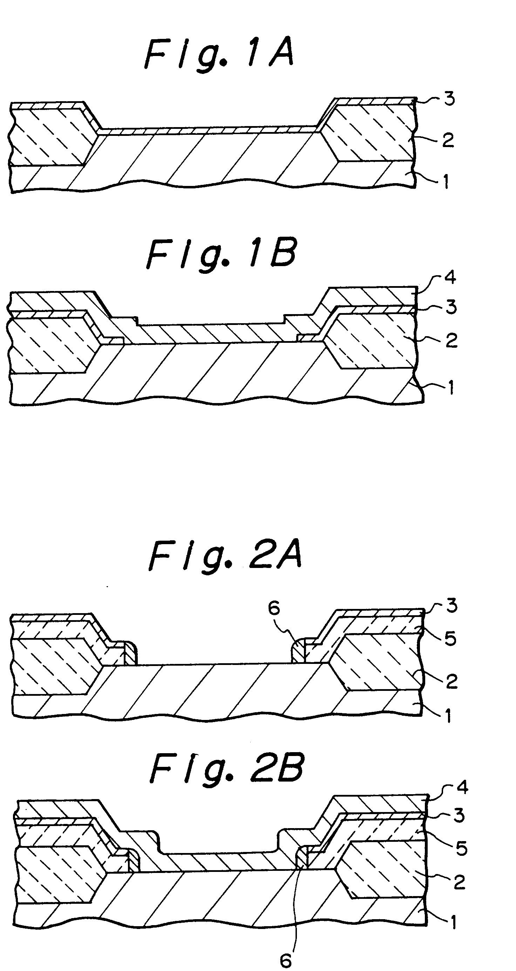

Figures 1A and 1B show a first embodiment of the present invention. A silicon substrate 1 has an insulation layer 2 of an oxide, for example, an isolation insulation layer formed by the LOCOS (local oxidation of silicon). An Si-Ge layer for forming a hetero-junction is intended to be deposited on the silicon substrate 1 exposed from the insulation layer 2, but in the present invention a protection layer 3 of, for example, $Si_3N_4$ , is first formed on the insulation layer 2 to cover the surface of the insulation layer 2 as shown in Fig. 1A and then a Ge-Si layer 4 is deposited on the silicon substrate 1 by chemical vapor deposition (CVD) as shown in Fig. 1B. Since the $Si_3N_4$ layer 3 does not contain oxygen, the Si-Ge layer 4 is not contaminated with oxygen originated from the insulation layer 2 and an epitaxial growth giving an excellent crystalinity is made possible.

Figs. 2A and 2B show a second embodiment of the present invention. a silicon substrate 1 has an insulation layer 2 for element isolation formed by the LOCUS and an interlayer insulation layer 5 of $SiO_2$, etc. is formed on the substrate 1 or the insulation layer 2. An Si-Ge layer 4 is intended to be epitaxially grown on a surface of the silicon substrate 1 exposed in an opening.

It is generally difficult to cover a sharp step at a side wall of the opening of the insulation layer 5 by a protection layer of $Si_3N_4$ etc. Accordingly, by a known method using the anisotropic etching, a second protection layer 6 is formed on the side wall at the step of the opening as shown in Fig. 2A and then an Si-Ge layer 4 is deposited on the silicon substrate 1 by CVD as shown in Fig. 2B.

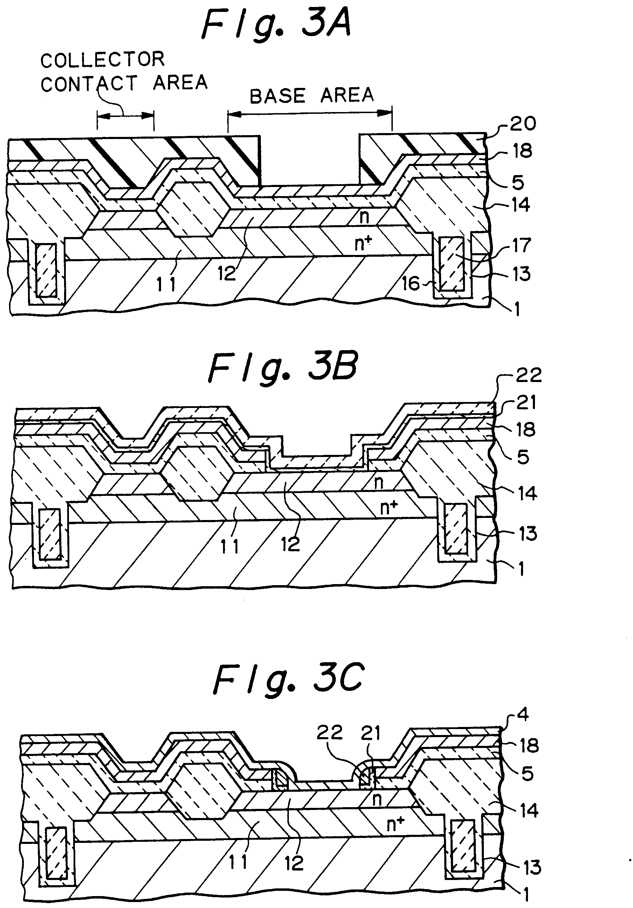

Figs. 3A to 3F show main steps of manufacturing a hetero-junction bipolar transistor having an Si/Si-Ge junction in which the present invention is applied.

Referring to Fig. 3A, an $n^+$- type buried layer 11 and an n-type collector layer 12 of an epitaxial layer are formed in a silicon substrate 1. Then a trench isolation structure 13 and a LOCOS isolation structure 14 are formed in the substrate 1 for element isolation. the trench isolation structure 13 comprises an oxide insulating layer 16 in which a poly-silicon layer 17 is buried. The LOCOS isolation structure 14 leaves the surface of the silicon substrate 1 exposed for a base area and a collector contact area.

An interlayer insulation layer 5 of $SiO_2$ having a thickness of about 100 nm and then a poly-silicon layer 18 having a thickness of about 300 nm are deposited on the entire surface of the substrate 1. The poly-silicon layer 18 acts as a protection layer during the following deposition of an Si-Ge layer and comprises a take-out base electrode for the base layer. Therefore, a p-type dopant is introduced in the poly-silicon layer 18 to thereby lower the electric resistance.

A resist mask 20 is formed above the substrate 1. The resist mask 20 leaves a base area exposed in an opening. The poly-silicon layer 18 and the interlayer insulation layer 5 exposed in the opening are etched by a known reactive ion etching (RIE).

Referring to Fig. 3B, after the substrate 1 is exposed at the base area, an $SiO_2$ layer 21 having a thickness of about 5 nm and an $Si_3N_4$ layer 22 having a thickness of about 40 nm are deposited in this order on the substrate 1.

Then an anisotropic etching is effected on the $Si_3N_6$ and $SiO_2$ layers 22 and 21 by an RIE until the substrate 1 is exposed. As a result, the $Si_3N_4$ layer 22 remains only at the side wall portion of the step of the interlayer insulation layer 5 and the poly-silicon layer 18, as shown in Fig. 3C. This remaining $Si_3N_4$ layer 22 acts as a second protection layer for covering the poly-silicon layer 18. The $SiO_{32}$ layer 21 is formed on a surface of the silicon substrate 1 to prevent crystal strains which would be formed if an $Si_3N_4$ layer is directly formed on the silicon substrate.

Then an Si-Ge layer 4 is grown entirely on the substrate 1 by a CVD with source gases of, for example, $Si_2H_6$ (disilane) and $GeH_4$ . The grown Si-Ge layer 4 forms a base layer having a hetero-junction with the exposed silicon substrate 1. In this Example, a p-type dopant such as $B_2H_4$ (diborane) is added to the source gases, to form a p-type base layer. The conditions for growing the Si-Ge layer 4 are as below.

Flow rate of source gases:

| | |
|---|---|
| $Si_2H_6$ | 10 SCCM |
| $GeH_4$ | 10 SCCM |
| $B_2H_4$ | 0.05 SCCM |

| | |
|---|---|
| Flow rate of carrier gas ($H_2$): | 10 1/min |
| Reaction gas pressure: | 0.8 Torr (total) |
| Substrate temperature: | 600°C (heated by lamp) |

By the above, a p-type Si-Ge layer having a composition of $Si_{0.8}Ge_{0.2}$, a concentration of the dopant of 5.0 x $10^{19}$ atom/cm$^3$ and a thickness of 50 nm was formed. The Si-Ge layer 4 is epitaxially grown on the exposed silicon substrate 1 but is deposited as a poly-crystalline layer on the poly-silicon layer 18 and $Si_3N_4$ layer 22.

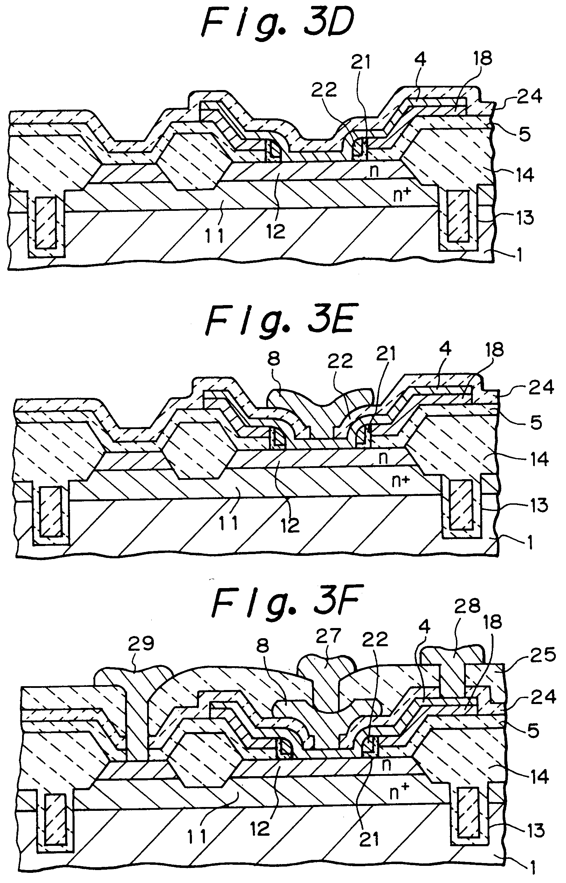

Referring to Fig. 3D, the Si-Ge layer 4 and the poly-silicon layer 18 are patterned to a form including a pattern of a take-out base electrode. The poly-silicon layer 18 and the Si-Ge layer 4 existing thereon compose the take-out base electrode and the poly-silicon layer 18 is effective in lowering the base resistance. Then an insulation layer 24 having a thickness of about 50 nm is deposited entirely on the substrate 1 by CVD.

Referring to Fig. 3E, an opening is formed in the insulation layer 24 for exposing the Si-Ge layer 4 in a base area. An As-doped poly-silicon layer is deposited entirely on the substrate 1 and patterned to form an emitter 8.

Referring to Fig. 3F, an insulation layer 25 of phospho-silicate glass (PSG) is deposited entirely on the substrate 1. Contact holes are formed in an area for the emitter 8, an area for the take-out base electrode of the Si-Ge layer 4, and an area for a collector contact. The formation of these contact holes may be carried out in a process in which the end point of etching is selected by an exposure of the silicon surface or the Si-Ge surface.

Then an emitter electrode 27, a base electrode 28 and a collector electrode 29 are formed by depositing an aluminum layer entirely on the substrate 1 and patterning it. Thus, a hetero-junction bipolar transistor is accomplished.

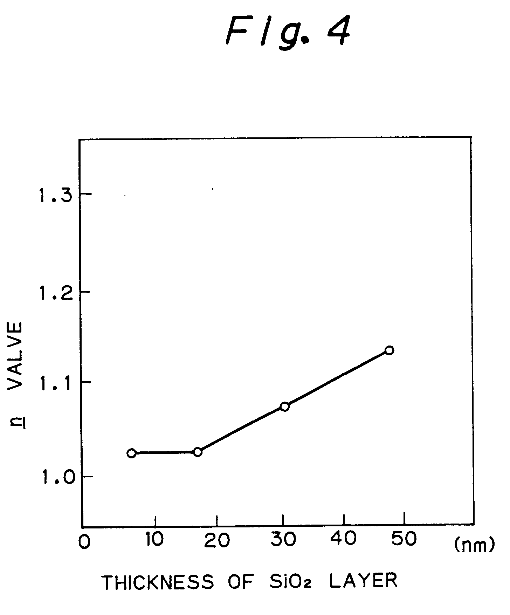

Fig. 4 shows a relationship between the thickness of the $SiO_2$ layer 21 formed on the side wall of the step of the interlayer insulation layer 5 in the base area in the process as shown in Figs. 3A to 3F and the n value expressing the current in the forward direction of the collector-base junction, called "ideal factor" or "diode factor". As seen in Fig. 4, while the thickness of the $SiO_2$ layer 21 is thin, the n value is almost one, but if the thickness of the $SiO_2$ layer 21 is increased, the n value is rapidly increased. This is considered because since the $SiO_2$ layer 21 is not completely covered with the protecting layer 3 or the $Si_3N_4$ layer 22 and a part of the surface of the $SiO_2$ layer 21 remains exposed and in contact with $GeH_4$, as the thickness of the $SiO_2$ layer 21 increases to a certain extent, crystal defects affected by oxygen derived from that contact surface cannot be neglected.

As shown in the above, it is apparent that only a small surface of the $SiO_2$ layer 21 such as the side wall portion critically affects the crystallinity of the Si-Ge layer 4 and therefore it is basically necessary to cover a large area of the insulating layer 2 by a protection layer.

The same conclusion is reached from other experiment results. Namely, when an Si-Ge layer about 100 nm thick was grown on an $SiO_2$ layer, the surface roughness of the Si-Ge layer was about 20 nm, but when an Si-Ge layer about 100 nm thick was grown on an $SiO_2$ layer after the surface of the $SiO_2$ layer was covered with an $Si_3N_4$ layer, the surface roughness of the Si-Ge layer is less than 5 nm. Further, the oxygen concentration in the grown Si-Ge layer was about $10^{20}$ atom/cm$^3$ in the former, but was about $10^{16}$ atom/cm$^3$ in the latter. Thus, it is clear that a surface of an insulation layer containing oxygen should not be unlimitedly exposed to a gaseous germanium source such as $GeH_4$.

Since Fig. 4 shows that a small exposed surface of a side wall of an $SiO_2$ layer having a thickness of about several tens nano meters affects the crystallinity of the Si-Ge layer, it is generally necessary to cover a side wall portion of an insulation layer containing oxygen and having a thickness of 100 nm or more with a second protection layer.

The above Example is an n-p-n type hetero-junction bipolar transistor (HBT), but the present invention is also applicable to a p-n-p type HBT. Also, the present invention is applicable to an HBT in which a Ge concentration continuously changes from zero at the collector side to a maximum at the emitter side in the SI-Ge layer 4, or to an HBT in which a Ge layer is replaced for the Si-Ge layer 4, or to other types.

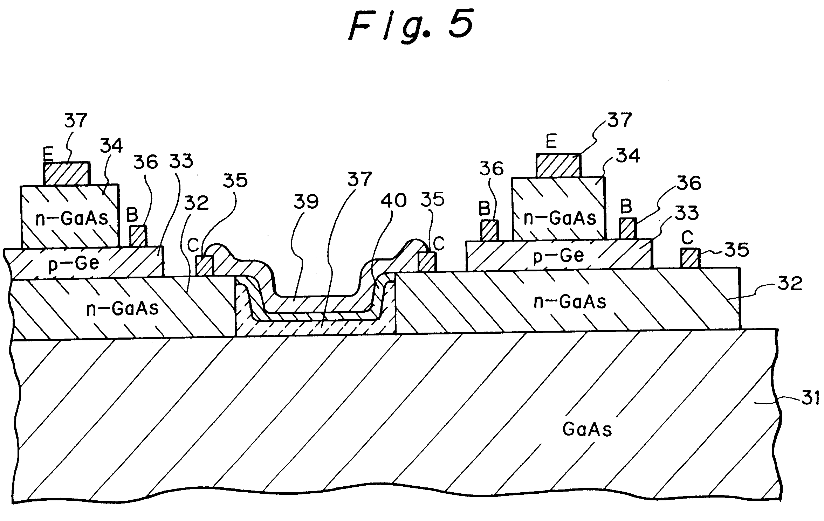

Fig. 5 shows another embodiment of the present invention in which a germanium-containing layer is used as an interconnection layer between transistors comprising compound semiconductors. In Fig. 5, 31 denotes a semi-insulating GaAs common substrate on which bipolar transistors $Tr_1$ and $Tr_2$ are formed. In each transistor $Tr_1$ or $Tr_2$, 32 denotes an n-type GaAs collector layer, 33 a p-type Ge base layer, 34 an n-type GaAs emitter layer, 35 a collector electrode, 36 a base electrode, 37 an emitter electrode. The thus formed bipolar transistors $Tr_1$ and $Tr_2$ are isolated from each other by cutting off a portion of the n-type GaAs layer 32 between the tran-

sistors $Tr_1$ and $Tr_2$.

An insulating layer 38 of $SiO_2$, for example, is formed on the GaAs substrate 31 where the n-type GaAs layer 32 is cut off between the transistors $Tr_1$ and $Tr_2$, to complete the element isolation. On the other hand, an interconnection layer 39 of, for example, Ge is formed to electrically connect between the transistors $Tr_1$ and $Tr_2$. In such a case, the Ge interconnection layer 39 may be formed on the insulation layer 38 of $SiO_2$ and therefore there are problems mentioned before because a Ge layer is grown on an insulation layer containing oxygen.

Therefore, the present invention is preferably applied to this structure. To prevent a deterioration of the crystal quality of the Ge interconnection layer 39, a protection layer 40 of, for example, $Si_3N_4$ is first formed on the $SiO_2$ insulation layer 38 before the Ge interconnection layer 39 is deposited thereon.

Thus, the present invention is applicable to various devices, not limited to bipolar transistors or a formation of a hetero-junction.

## Claims

1. A process for forming a germanium-containing layer on a substrate having an oxygen-containing insulation layer on a surface thereof, said process comprising the steps of:

forming a protection layer on a surface of the oxygen-containing insulation layer, said protection layer preventing a decomposition of said oxygen-containing insulation layer as a result of reaction with a germanium-containing gas; and then

forming the germanium-containing layer on the substrate by a chemical vapor deposition using the germanium-containing gas.

2. A process for manufacturing a semiconductor device, comprising the steps of:

locally forming an oxygen-containing insulation layer on a semiconductor substrate, said insulation layer having a top surface and a side wall, a portion of a surface of said semiconductor substrate being exposed;

forming a protection layer on the top surface and the side wall of the oxygen-containing insulation layer, said protection layer preventing a decomposition of said oxygen-containing insulation layer due to a reaction of oxygen in said oxygen-containing insulation layer with a germanium-containing gas; and then

forming a germanium-containing layer on the exposed semiconductor substrate by a chemical vapor deposition using the germanium-containing gas.

3. A process as claimed in claim 1 or 2, wherein said germanium-containing layer is of germanium.

4. A process as claimed in claim 1, 2 or 3, wherein said germanium-containing gas is gerane gas.

5. A process as claimed in claim 1 or 2, wherein said germanium-containing layer is of silicon-germanium.

6. A process as claimed in claim 1, 2 or 5, wherein said germanium-containing gas is a mixture of silane gas and gerane gas.

7. A process claimed in any preceding claim, wherein said oxygen-containing insulation layer is of silicon dioxide, phosphor-silicate glass or boro-phospho-silicate glass.

8. A process claimed in any preceding claim, wherein said protection layer is of silicon nitride, silicon oxynitride or silicon.

9. A process as claimed in any preceding claim, wherein said substrate is a single crystalline semiconductor and said germanium-containing layer is epitaxially grown onto the single crystalline semiconductor.

10. A process as claimed in claim 1 and any one of claims 3 to 8 when appended to claim 1, wherein said substrate is of a semiconductor, a metal or an insulator.

11. A process as claimed in claim 1 and any one of claims 3 to 10 when appended to claim 1, wherein said insulation layer is formed locally on the surface of the substrate so that the substrate has an exposed surface and said germanium-containing layer is formed on the exposed surface of the substrate and said protection layer.

12. A process as claimed in claim 11, wherein said insulation layer is covered by said protection layer on a top surface and side walls thereof.

13. A process as claimed in claim 2 and any one of claims 3 to 9 when appended to claim 2, wherein said semiconductor device is a hetero-junction bipolar transistor.

14. A process as claimed in claim 2 and in any one of claims 3 to 9 or 13 when appended to claim 2, wherein said semiconductor device is a high electron mobility transistor.

# F l g. 1A

# F l g. 1B

# F l g. 2A

# F l g. 2B

# F l g. 3A

COLLECTOR
CONTACT AREA

BASE AREA

20
18
5
14
17
13
1

n

n+

11   12   16

# F l g. 3B

22
21
18
5
14
13
1

n

n+

11   12

# F l g. 3C

4

22   21

18
5
14
13
1

n

n+

11   12

# Fig. 3D

# Fig. 3E

# Fig. 3F

# F l g. 4

# Fig. 5

EP 0 484 056 A1

## European Patent Office

# EUROPEAN SEARCH REPORT

Application Number

EP 91 30 9854

### DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| P,X | EP-A-0 430 280 (HEWLETT-PACKARD)<br>* column 3, line 26 - column 4, line 19; claims 1,6-8 *<br>--- | 1,5-11 | H01L21/20<br>H01L21/331<br>H01L21/335 |
| P,X | EP-A-0 430 279 (HEWLETT-PACKARD)<br>* column 5, line 11 - column 6, line 4; claims; figures 2-9 *<br>--- | 2,5-9,13 | |
| Y | EP-A-0 147 471 (SONY)<br>* page 4, line 4 - line 26 *<br>* page 6, line 2 - line 22 *<br>--- | 3,4 | |
| Y | APPLIED PHYSICS LETTERS.<br>vol. 57, no. 6, 6 August 1990, NEW YORK US<br>pages 599 - 601;<br>TAKAHASI ET AL: 'Reduction reaction of native oxide at the initial stage of GeH4 chemical vapor deposition on (100)Si'<br>* abstract *<br>--- | 3,4 | |
| A | EP-A-0 382 947 (IBM)<br>* column 6, line 47 - column 8, line 11; figures * | 1-14 | TECHNICAL FIELDS SEARCHED (Int. Cl.5) |
| | ----- | | H01L |

The present search report has been drawn up for all claims

| Place of search | Date of completion of the search | Examiner |
|---|---|---|
| THE HAGUE | 10 FEBRUARY 1992 | GORI P. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
............................................................................
& : member of the same patent family, corresponding document

EPO FORM 1503 03.82 (P0401)